(19) Europäisches Patentamt
European Patent Office
Office européen des brevets

(11) **EP 4 335 819 A1**

(12) **EUROPEAN PATENT APPLICATION**

(43) Date of publication:
**13.03.2024   Bulletin 2024/11**

(21) Application number: **22382826.0**

(22) Date of filing: **06.09.2022**

(51) International Patent Classification (IPC):
**C01B 32/15** (2017.01)   **C09K 11/07** (2006.01)
**H01G 11/00** (2013.01)

(52) Cooperative Patent Classification (CPC):
**H01B 1/06; C01B 32/15; H01G 11/00; H10K 30/81; H10K 71/60; H10K 85/20;** C01P 2002/82; C01P 2002/84; C01P 2004/64

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**
Designated Extension States:
**BA ME**
Designated Validation States:
**KH MA MD TN**

(71) Applicant: **Universidad Autónoma de Madrid
28049 Madrid (ES)**

(72) Inventors:
• **GUTIÉRREZ SÁNCHEZ, Cristina**
  **E-28049 Madrid (ES)**
• **MARTÍNEZ PERIÑÁN, Emiliano**
  **E-28049 Madrid (ES)**
• **LORENZO ABAD, Ma Encarnación**
  **E-28049 Madrid (ES)**

(74) Representative: **ABG Intellectual Property Law, S.L.
Avenida de Burgos, 16D
Edificio Euromor
28036 Madrid (ES)**

(54) **BORON-NITRIDE CARBON NANODOT ELECTRODES AND PROCESS FOR THEIR PREPARATION**

(57)   The present invention relates to a method for the preparation of a boron-carbon doped nanomaterial and to a method for the preparation of an electrode comprising nanostructures of said boron-carbon doped material. The invention also relates to the material and electrodes resulting from said methods and to the use of said electrode as electrocatalyst, capacitator or in an electrochemiluminescent sensor.

**EP 4 335 819 A1**

## Description

## FIELD OF THE INVENTION

The present invention relates to a method for the preparation of a boron-doped carbon nanomaterial and to a method for the preparation of an electrode comprising nanostructures of said boron doped carbon material. The invention also relates to the material and electrodes resulting from said methods and to the use of said electrode as electrocatalyst, capacitor or as an electrochemiluminescent sensor.

## BACKGROUND

Carbon nanodots are nanoparticles having an average size between 1 - 100 nm, typically between 1-10 nm, which are soluble in water and are fluorescent, unlike other forms of carbon, such as nanotubes, graphite or graphene. Carbon nanodots are conjugated systems mostly made of carbon atoms in the $sp^2$ hybridization state. Compared to inorganic quantum dots or organic dyes, carbon nanodots are superior in terms of aqueous solubility, robust chemical inertness, ease of functionalization, resistance to photobleaching, toxicity and biocompatibility. These properties have led the scientific community to develop a large number of applications involving carbon nanodots in different fields, including bioimaging, optoelectronics, sensor, Surface Enhanced Raman Scattering, and photocatalysis.

Several methods are known in the art for the synthesis of carbon nanodots and have been reviewed by Li and co-workers in J. Mater. Chem., 2012, 22, 24230. Physical top-down methods include arc discharge, laser ablation/passivation, and plasma treatment of carbon materials. Chemical bottom-up methods for the synthesis of carbon nanodots include electrochemical synthesis, combustion/thermal/hydrothermal/acidic oxidation, supported synthesis, microwave/ultrasonic and solution chemistry methods. These methods employ different starting materials (e.g. graphene sheets, soot from combustion processes, small organic molecules, saccharides, etc.) and produce carbon dots with tunable size and photoluminescence properties.

Carbon nanodot materials doped with nitrogen and/or boron have also been reported in the art. Doping of carbon nanodots with heteroatoms, such as B, N, S and P allows adjusting their electronic structure and optical properties by generation of n-type or p-type carriers. Doped carbon nanodots are typically made via bottom-up synthetic methods, such as hydrothermal or microwave assisted synthesis of carbon dots carried out in the presence of an additive suitable for introducing the doping agent in the carbon nanodot. For instance, doping with nitrogen of carbon nanodots has been reported by synthesis of carbon nanodots in the presence of a nitrogen source, such as urea or formamide. Similarly, doping with boron of carbon nanodots has been reported by synthesis of carbon nanodots in the presence of a boron source, such as boric acid. Miao and co-workers reviewed in Nano Today 2020, 33, 100879 several methods and raw materials for the preparation of carbon nanodots doped with boron and/or nitrogen, among other possible doping agents.

In particular, Jahan and co-workers have described in Anal. Chem. 2013, 85, 10232-10239 a hydrothermal method for the preparation of boron-nitrogen doped carbon nanodots using N-(4-hydroxyphenyl)glycine as precursor for carbon nanodot doped with nitrogen and boric acid as boron source. The resulting carbon nanodot is disclosed as having carboxyl terminal groups. The authors further disclose the use of this material in the preparation of a fluorescent FRET system for the sensing of dyes in food samples. The authors are however silent about the grafting of said material on the surface of an electrode.

A strategy for immobilizing nitrogen-doped carbon nanodots on the surface of carbon materials, such as graphite, was reported by Gutiérrez-Sánchez and co-workers in Carbon, 2020, 159, 303-310. In a first step, said method contemplates the preparation of a nitrogen-doped carbon nanodot by microwave irradiation of a water solution of fructose and urea as nitrogen source. The formed nanodot comprises about 21% nitrogen content, part of which is in the form of aromatic amino end groups. The resulting nitrogen-doped carbon nanodots are then treated with sodium nitrite to convert the aforementioned aromatic amine groups into diazonium groups. Said diazonium end groups are suitable for electrochemical reaction as they are prompt to release nitrogen gas. This functionality was used by the authors to graft electrochemically the nitrogen-doped carbon nanodots on the surface of a graphite material, thereby producing an electrode. The aggregates of carbon nanodots on the surface of the graphite electrode exhibit a height of about 4-6 nm, as measured by Atomic Force Microscopy. In particular, said material appears to aggregate in the form of collar beads. The authors further disclose that said electrografting process allows improving the conductivity and electrochemiluminescence of the electrode, since the charge transfer resistance of the electrode is reduced a 2.5-fold when nitrogen-doped carbon nanodots are electrografted on the surface of the electrode. The thus formed electrode was further used in the preparation of an electrochemiluminescent sensor for taurine.

In a slightly different approach, Guerrero-Esteban and co-workers disclosed in Sensors and Actuators: B Chemical, 2021, 330, 129389 the synthesis of a nitrogen-doped carbon nanodot material by microwave-assisted synthesis using an aqueous solution of arginine and 3, 3'-diamino-N-methyldipropylamine as starting material. The thus prepared carbon nanodot material comprises about 21.93% nitrogen and comprises carboxyl end groups. A broad fluorescence emission peak at 383 nm is observed when the material is excited at 320 nm. The resulting nitrogen-doped carbon nanodot is then treated with sodium nitrite to convert the aforementioned aromatic amine groups into diazonium groups. Said diazonium end groups are suitable for electrochemical reaction as they are prompt to release nitrogen gas. This functionality was used by the authors to graft electrochemically the nitrogen-doped carbon nanodots on the surface of a graphite material, thereby producing an electrode. The aggregates of carbon nanodots on the surface of the electrode exhibited a height of about 4-6 nm, as measured by Atomic Force Microscopy. In particular, said material appears to aggregate in globular form, presumably by reaction of the diazotized carbon nanodot with a grafted carbon nanodot. The thus formed electrode was used as a sensor for glyphosate. The authors are however silent about the use of boric acid in the preparation of the N-doped carbon nanodots.

From what is disclosed in the art, it derives that there is still a need for providing improved electrodes comprising carbon nanodot materials, for instance electrodes having improved capacitance or electrochemiluminescence.

## SUMMARY OF THE INVENTION

After exhaustive research, the inventors have developed a boron-nitrogen carbon nanodot material bearing carboxyl end groups combined with aromatic amine groups suitable for forming diazonium groups. The carbon nanodot material according to the invention is suitable for preparing electrodes by electrografting, using the reduction of diazonium groups formed on the carbon nanodots surface. Passivation of the carbon nanodot material is advantageously not required. The inventors have found that the boron-nitrogen carbon nanodot material of the invention surprisingly forms well-defined nanostructures on the surface of the electrode when submitted to electrografting. It was found that the boron-nitrogen carbon nanodot material forms aggregates of hexagonal shape on the surface of the electrode. Unlike other aggregates prepared by diazonium-mediated electrografting processes disclosed in the art, the hexagonal nanostructures of the invention exhibit a height as measured by atomic force microscopy of below 2 nm and cover the whole surface of the electrode. In addition, the inner part of the formed hexagon presents a hollow structure, thereby providing a porous material. The formation of such hexagonal nanostructures was totally unexpected, for carbon nanodots material known in the art typically aggregate to form isolated beads or spheres when submitted to electrografting carried out in the presence of sodium nitrite for forming diazonium groups, said aggregates exhibiting a height of at least 4 nm as measured by atomic force microscopy and not forming empty cavities within the surface of the electrode. In particular, the inventors have found that the electrografting of boron-nitrogen carbon nanodot material on the surface of a carbon-based electrode allows improving the conductivity of said electrode as well as its electrochemiluminescence and capacitance. It was in particular totally unexpected, in view of the state of the art, that the use of a boron-nitrogen carbon nanodot material in the preparation of an electrode by electrografting using the reduction of diazonium groups on the carbon nanodot material would improve significantly the capacitance of the electrode. Without being bound to any specific theory, it is believed that it is the formation of singular hexagonal nanostructures leading to the formation of a porous electrode that provides the required structure at microscopic scale to allow the electrode surface to store electrons, which results in an improved capacitance of the electrode.

Thus, in a first aspect, the invention relates to a method for the preparation of a boron-doped carbon nanodot material comprising the steps of:

(i) providing an aqueous solution comprising an alpha amino acid, boric acid and a polyamine compound for forming carbon nanodots having amino end groups, wherein the molar ratio of alpha amino acid to boric acid is 2:1, the molar ratio of alpha amino acid to primary amine groups in the polyamine compound is essentially 1:2 and the concentration of alpha amino acid is comprised between 2 mM and 6 mM;

(ii) heating the solution provided in step (i) in a closed vessel at a temperature of between 180 °C and 250 °C so as to avoid the evaporation of water as the solvent.

A second aspect of the invention thus relates to a product obtainable by the method of the first aspect of the invention.

The method of the first aspect of the invention allows preparing a material having specific features. A third aspect of the invention thus relates to a boron-doped carbon nanodot material having free amine end groups for forming diazonium end groups characterized in that:

(i) said material exhibits a fluorescence emission peak at about 360 nm when irradiated with light of a wavelength of about 310 nm; and/or

(ii) 100 moles of said material substantially consist of from 40 to 50 moles of carbon atoms, from 5 to 15 moles of hydrogen atoms, from 15 to 25 moles of nitrogen atoms and from 10 to 40 moles of oxygen and/or boron atoms; and/or

(iii) said material exhibits infrared absorption peaks at one or more wavelengths selected from the group consisting of 3480 $cm^{-1}$, 2950 $cm^{-1}$, 1715 $cm^{-1}$, 1450 $cm^{-1}$, 1377 $cm^{-1}$, 1383 $cm^{-1}$ and 801 $cm^{-1}$; and/or

(iv) said material has an average particle size of between 10 and 50 nm as measured by dynamic light scattering; and/or

(v) said material exhibits a zeta potential lower than -5 mV at pH values higher than 6 at a concentration of boron-doped carbon nanodot material in water of 1.30 mg per mL.

A fourth aspect of the invention thus relates to an aqueous composition comprising the material of the third aspect of the invention. Said composition preferably comprises the material of the third aspect of the invention in a concentration of from 1 to 3 mg per mL.

The material of the second, third or fourth aspect of the invention is useful in the preparation of an electrode by electrografting of the boron-doped carbon nanodot material on the surface of an electrode support. Thus, a fifth aspect of the invention relates to a method for the preparation of an electrode comprising the steps of:

(i) submitting a product as defined in the second aspect of the invention or an aqueous composition as defined in the fourth aspect of the invention to reaction conditions suitable for converting at least one amine group of the boron-doped carbon nanodot material in a diazonium group;

(ii) providing an electrode support consisting essentially of a carbon material;

(iii) contacting the electrode support provided in step (ii) with the product or composition provided in step (i) while applying a potential being equal to or inferior to -0.7 V, so as to promote the grafting of the boron-doped carbon nanodot material comprised in the mixture resulting from step (i) on the surface of the electrode support such that the grafted boron-doped carbon nanodot material has a height inferior to 2 nm as measured by atomic force microscopy.

A sixth aspect of the invention relates to an electrode obtainable according to the method of the fifth aspect of the invention.

The method of the fifth aspect of the invention allows preparing an electrode having specific features, in particular having a high capacitance. A seventh aspect of the invention thus relates to an electrode comprising a boron-doped carbon nanodot material grafted on a carbon material characterized in that:

(i) said electrode exhibits Raman absorption peaks at one or more wavelengths selected from the group consisting of 500 cm$^{-1}$, 1230 cm$^{-1}$, 2911 cm$^{-1}$ and 2965 cm$^{-1}$; and/or

(ii) said electrode exhibits a charge resistance for electron transfer of about 240 $\Omega$ as measured by electrochemical impedance spectroscopy; and/or

(iii) said electrode exhibits a reduction potential of about 0.1 V and an oxidation potential of about 0.4 V as measured by cyclic voltammetry using a Ag/Ag-Cl reference electrode and a platinum wire counter electrode at 10 mV/s scan rate in 0.1 M phosphate buffer of pH 7.4 containing 0.1 M KCl; and/or

(iv) said material exhibits a capacitance higher than 1000 $\mu$F per cm$^2$ at a scan rate of 0.005 V/s as measured by cyclic voltammetry.

The electrodes of the sixth and seventh aspect of the invention advantageously benefit from large electrochemical surface area and are useful in several applications, such as electrocatalysis, electrochemiluminescence, and capacitators. The eighth aspect of the invention thus relates to the use of an electrode as defined in the sixth or seventh aspect of the invention as capacitator, or as electrocatalyst, or as electrochemiluminescent electrode.

**BRIEF DESCRIPTION OF THE DRAWINGS**

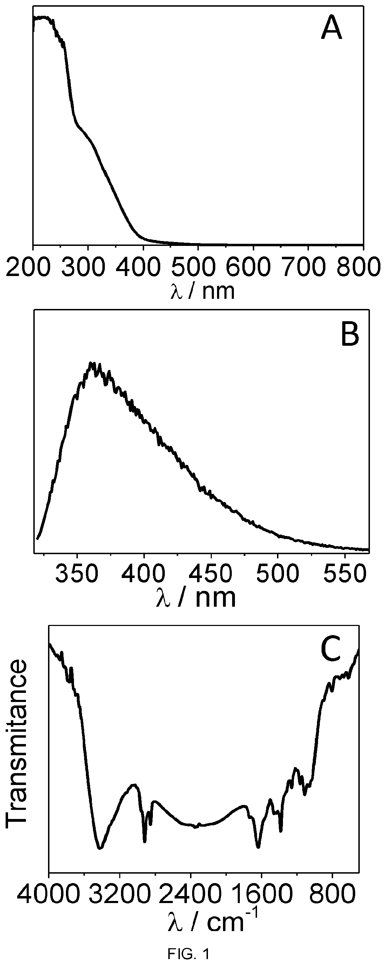

Fig. 1 (A) describes the UV-Vis absorption spectrum of the boron-nitrogen carbon nanodot material (B-CND material) prepared according to the Example 1. Fig. 1 (B) describes the fluorescence emission spectrum of the B-CND material prepared according to the Example 1 when irradiated with light at a wavelength of 310 nm. Fig. 1 (C) describes the FT-IR absorption spectrum of the B-CND material prepared according to the Example 1.

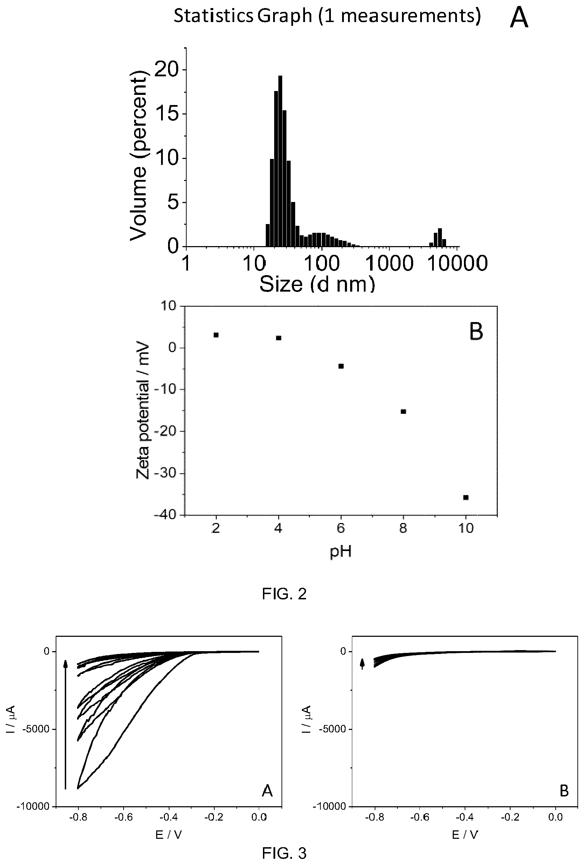

Fig. 2 (A) shows the distribution of particle size of the B-CND material prepared according to the Example 1 as measured by Dynamic Light Scattering. Fig. 2 (B) shows the evolution of the zeta potential of the aqueous solution of the B-CND material prepared according to Example 1 in function of the pH of the aqueous solution.

Fig. 3 shows multiple scans of cyclic voltammetry for (A) the electrografting of diazotized B-CND on an HOPG electrode carried out between 0.0 and -0.8 V at 0.010 V/s; and (B) the electrografting of non-diazotized B-CND on an HOPG electrode carried out between 0.0 and -0.8 V at 0.010 V/s.

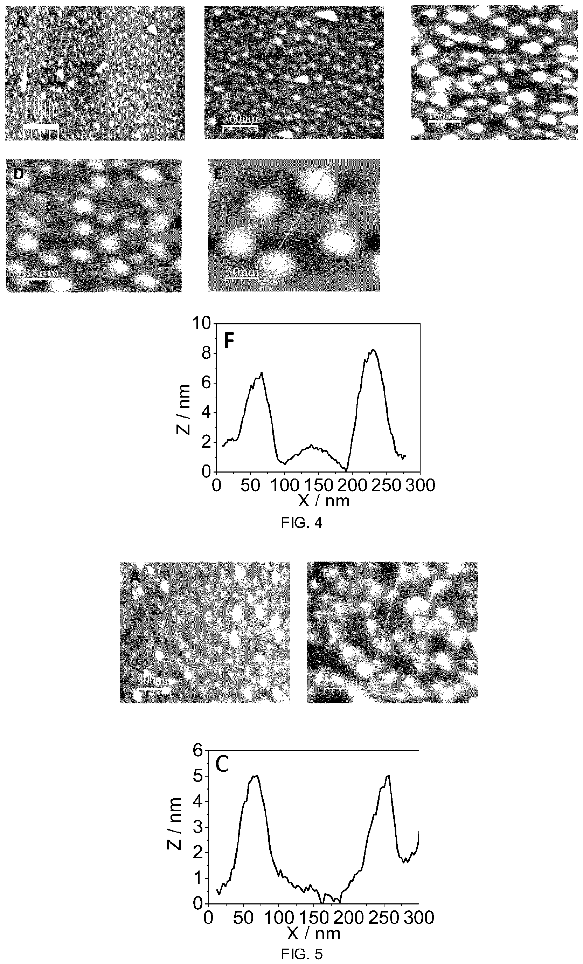

Fig. 4 (A)-(E) shows AFM topographic images at different places of the sample of an HOPG electrode exposed to 10 electrochemical reductive cycles between 0.0 V and -0.8 V at 0.010 V/s in the presence of B-CND treated with $1.5\times10^{-2}$ M NaNO$_2$ in 0.5 M HCl for 1 h. Fig. 4 (F) shows the profile of the cut represented by a line in Fig. 4 (E).

Fig. 5 (A)-(B) shows AFM topographic images at different places of the sample of an HOPG electrode exposed to 25 electrochemical reductive cycles between 0.0 V and -0.8 V at 0.010 V/s in the presence of B-CND treated with $1.5\times10^{-2}$ M NaNO$_2$ in 0.5 M HCl for 1 h. Fig. 5 (C) shows the profile of the cut represented by a line in Fig. 5 (B).

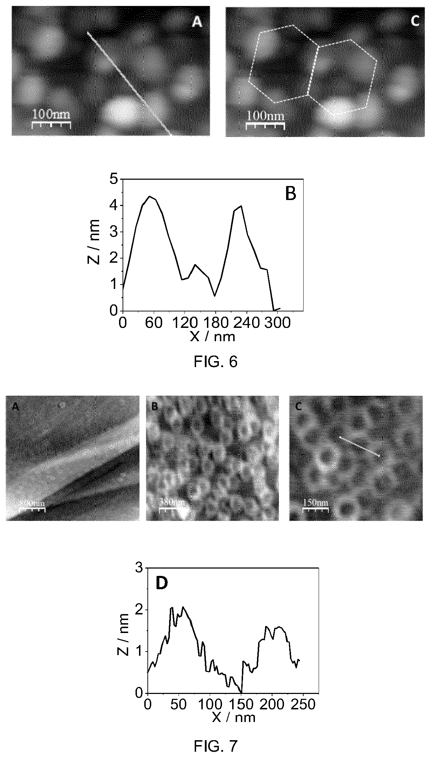

Fig. 6 (A)-(B) shows AFM topographic images at different places of the sample of an HOPG electrode exposed to 32 electrochemical reductive cycles between 0.0 V and -0.8 V at 0.010 V/s in the presence of B-CND treated with $1.5\times10^{-2}$ M NaNO$_2$ in 0.5 M HCl for 1 h. Fig. 6 (C) shows the profile of the cut represented by a line in Fig. 6 (B).

Fig.7 (A)-(D) shows AFM topographic images at different places of the sample of an HOPG electrode exposed to 40 electrochemical reductive cycles between 0.0 V and -0.8 V at 0.010 V/s in the presence of B-CND 1 treated with $1.5 \times 10^{-2}$ M $NaNO_2$ in 0.5 M HCl for 1 h. Fig. 7 (D) shows the profile of the cut represented by a line in Fig. 7 (C).

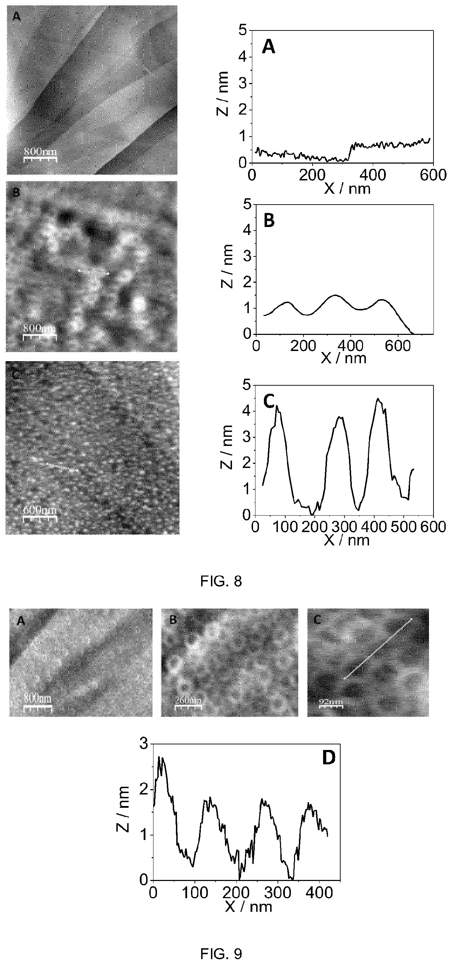

Fig. 8 (A-top) shows AFM topographic image of bare HOPG. Fig. 8 (A-bottom) shows the profile of the cut represented by a line in Fig. 8 (A-top). Fig. 8 (B-top) shows AFM topographic images of the sample of an HOPG electrode exposed to 50 electrochemical reductive cycles between 0.0 V and -0.8 V at 0.010 V/s in the presence of B-CND treated with $1.5 \times 10^{-2}$ M $NaNO_2$ in 0.5 M HCl for 1 h. Fig. 8 (B-bottom) shows the profile of the cut represented by a line in Fig. 8 (B-top). Fig. 8 (B-top) shows AFM topographic images of the sample of an HOPG electrode exposed to 50 electrochemical reductive cycles between 0.0 V and -0.8 V at 0.010 V/s in the presence of a carbon nanodot prepared according to Example 1 except for the absence of boric acid in the initial reaction mixture and treated with $1.5 \times 10^{-2}$ M $NaNO_2$ in 0.5 M HCl for 1 h. Fig. 8 (C-bottom) shows the profile of the cut represented by a line in Fig. 8 (C-top).

Fig.9 (A)-(D) shows AFM topographic images at different places of the sample of an HOPG electrode exposed to 50 electrochemical reductive cycles between 0.0 V and -0.8 V at 0.010 V/s in the presence of B-CND treated with $1.5 \times 10^{-2}$ M $NaNO_2$ in 0.5 M HCl for 1 h. Fig. 9 (D) shows the profile of the cut represented by a line in Fig. 9 (C).

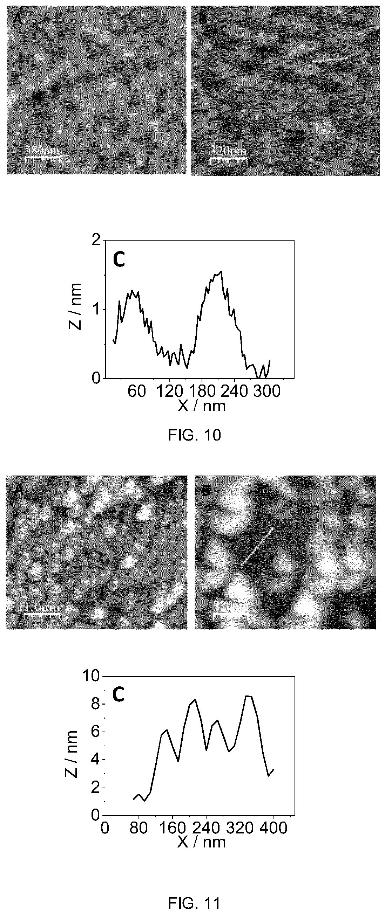

Fig. 10 (A)-(C) shows AFM topographic images at different places of the sample of an HOPG electrode exposed to 60 electrochemical reductive cycles between 0.0 V and -0.8 V at 0.010 V/s in the presence of B-CND treated with $1.5 \times 10^{-2}$ M $NaNO_2$ in 0.5 M HCl for 1 h. Fig. 10 (C) shows the profile of the cut represented by a line in Fig. 10 (B).

Fig. 11 (A)-(C) shows AFM topographic images at different places of the sample of an HOPG electrode in the presence of B-CND treated with $1.5 \times 10^{-2}$ M $NaNO_2$ in 0.5 M HCl for 1 h exposed to a fixed potential of -0.6 V during 800 seconds. Fig. 11 (C) shows the profile of the cut represented by a line in Fig. 11 (B).

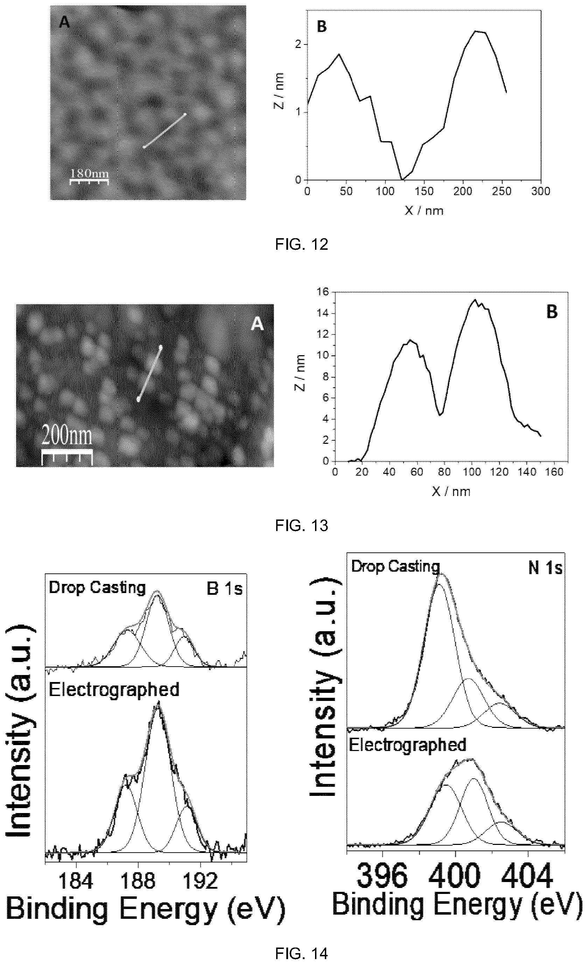

Fig. 12 (A) shows AFM topographic image of an HOPG electrode in the presence of B-CND treated with $1.5 \times 10^{-2}$ M $NaNO_2$ in 0.5 M HCl for 1 h exposed to a fixed potential of -0.7 V during 800 seconds. Fig. 12 (B) shows the profile of the cut represented by a line in Fig. 12 (A).

Fig. 13 (A) shows AFM topographic image of the sample of an HOPG electrode exposed to 50 electrochemical reductive cycles between 0.0 V and -0.8 V at 0.010 V/s in the presence of B-CND and in the absence of $NaNO_2$. Fig. 13 (B) shows the profile of the cut represented by a line in Fig. 13 (A).

Fig. 14 represents the XPS intensity spectra as a function of the binding energies related to B1s and N1s for an electrode prepared by drop-casting of B-CND as prepared according to Example 1 or by electrografting of diazotized B-CND as prepared according to Example 1.

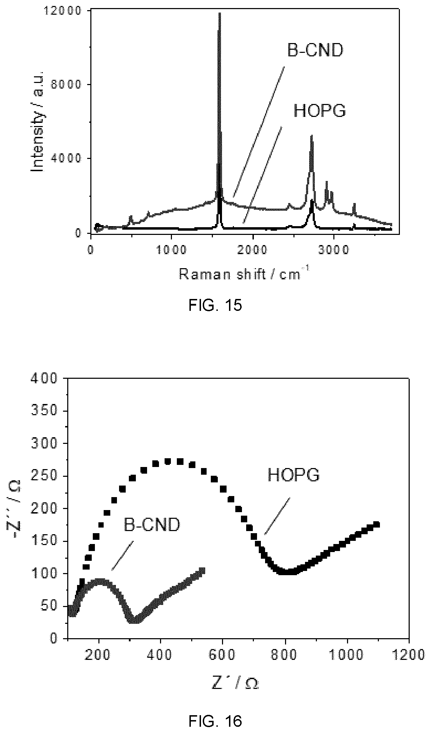

Fig. 15 represents the Raman spectra (intensity of absorption in function of the Raman shift) of an electrografted B-CND as prepared according to Example 2 using 50 electrochemical cycles and of bare HOPG surface.

Fig. 16 represents the Nyquist plot with a sinusoidal wave using $K_4[Fe(CN)_6]$ as an electrochemical probe for an electrografted B-CND as prepared according to Example 2 using 50 electrochemical cycles between 0.0 V and -0.8 V and of bare HOPG surface.

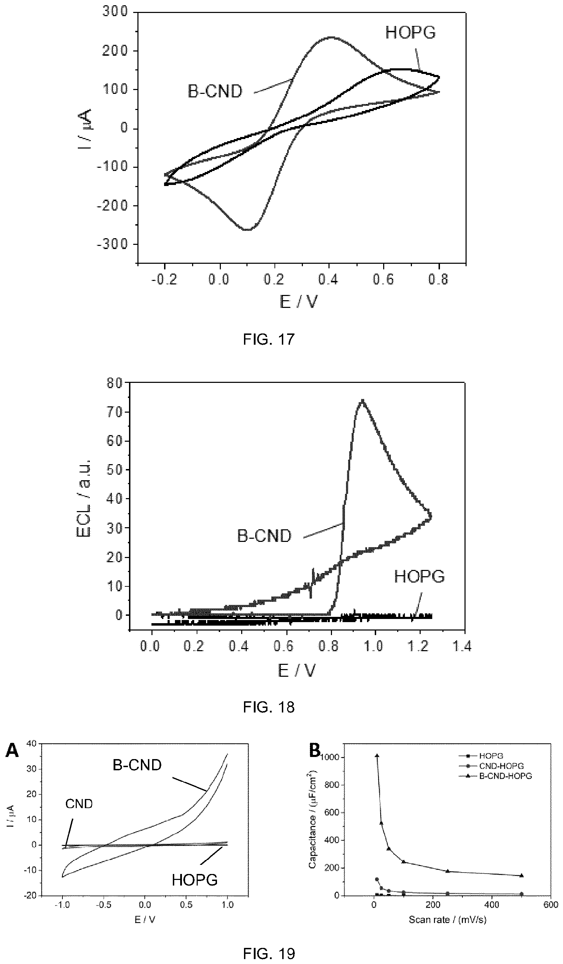

Fig. 17 represents the cyclic voltammetry curves of an electrochemical probe for an electrografted B-CND as prepared according to Example 2 using 50 electrochemical cycles between 0.0 V and -0.8 V and of bare HOPG surface at 0.01 V/s scan rate in 1.0 mM $K_4[Fe(CN)_6]$ in 0.1 M phosphate buffer pH 7.4 containing 0.1 M KCl.

Fig. 18 represents the electrochemiluminescence response in function of potential of an electrografted B-CND as prepared according to Example 2 using 50 electrochemical cycles between 0.0 V and -0.8 V and of bare HOPG surface in $[Ru(bpy)_3]^{2+}$ 2.0 mM in phosphate buffer 0.1M, pH=8.0.

Fig. 19 (A) represents the cyclic voltammetry curve at 100 mV/s scan rate in 0.5 M $H_2SO_4$ using a two electrodes configuration of (1) bare HOPG electrode; (2) HOPG covered with carbon nanodot by electrografting according to Example 2, with the exception that the carbon nanodot material was prepared as described in Example 1 in the absence of boric acid (CND); (3) HOPG covered with B-CNDs having hexagonal nanostructures by electrografting prepared according to Example 2 (B-CND). Fig. 19 (B) represents the capacitance in function of the scan rate of electrodes (1)-(3) studied in Fig. 19 (A).

## DETAILED DESCRIPTION

All terms as used herein in this application, unless otherwise stated, shall be understood in their ordinary meaning as known in the art. Other more specific definitions for certain terms as used in the present application are as set forth below and are intended to apply uniformly throughout the specification and claims unless an otherwise expressly set out definition provides a broader definition.

For the purposes of the invention, any ranges given include both the lower and the upper end-points of the range. Ranges given, such as temperatures, times, molar ratio, volume ratio and the like, should be considered approximate (i.e. with a 5% margin of variation around indicated point), unless specifically stated.

The term "carbon nanodot material" refers herein to a fluorescent material consisting essentially of carbon, having a particle size in the range 1-100 nm, and wherein at least 20% of the carbon atoms are conjugated. In the context of the invention, a "doped carbon nanomaterial" is a material wherein at least a portion of the carbon atoms forming a nanodot material are replaced by a heteroatom, said heteroatom being selected from the group consisting of O, N, S, B and P; preferably, said heteroatom being selected from N and B. In the context of the invention, a "boron-nitrogen carbon nanodot" or "boron-doped carbon nanodot" is a carbon nanodot material as defined above wherein at least a portion of the carbon atoms forming the nanodot material are replaced by B atoms and another portion of the carbon atoms forming the nanodot material are replaced by N atoms.

In the context of the invention, the term "hexagonal nanostructure", "hexagonal structure" or "hexagonal aggregates" are used interchangeably and refer to an assembly of doped carbon nanodot materials according to the invention on a surface consisting of a plurality of adjacent shapes covering the surface of an electrode support, said shapes being formed by six carbon nanodot materials arranged so as to form an hexagon of nanoscale dimensions (i.e. each side of the hexagon measures between 50 and 300 nm), such that each carbon nanodot material forming a first hexagon is shared with an hexagon that is adjacent to said first hexagon. In the context of the invention, the hexagonal nanostructure is preferably characterized in that said nanostructure has a height inferior to 2 nm as measured by atomic force microscopy.

The height profile, as measured by atomic force microscopy, corresponds to a plot of vertical displacement vs. distance obtained by using a sharp spike (known as a 'tip') mounted on the end of a cantilever to scan the surface of the specimen, line by line, and recording the force experienced by the tip as a function of position. The evolution of the force vs. the distance correlates with the height of the sample .The height as measured by atomic force microscopy thus corresponds to the average of maximal height of the peaks measured within the height profile. A suitable method is described for instance by Horcas and R. Fernández in Review of Scientific Instruments 78, 013705 (2007).

In the context of the invention, the "size" of a particle refers to the largest dimension of a particle. For instance, for an essentially spherical particle, the size of the particle refers to its diameter.

In the context of the invention, the term "$(C_1-C_6)$alkyl" refers to a saturated linear or branched hydrocarbon group comprising from 1 to 6 carbon atoms. Examples of $(C_1-C_6)$alkyl include methyl, ethyl, propyl, iso-propyl, butyl, iso-butyl, tert-butyl, pentyl and hexyl.

The materials according to the invention are herein characterized by a combination of parameters, such as fluorescence emission peak, composition and binding energies as measured by X-Ray Photoelectron Spectroscopy, IR absorption peaks, size of particles as measured by Dynamic Light Scattering, UV-Vis absorbance spectra, zeta potential, Raman absorption peaks, Resistance for charge transfer as measured by Electrochemical Impedance Spectroscopy, Redox potentials as measured by Cyclic Voltammetry and capacitance, as measured by cyclic voltammetry. Methods for measuring said parameters are well known in the art and will become apparent to the skilled person. The materials of the invention have also been analysed by microscopic techniques, such as Atomic Force Microscopy or Field Emission Scanning Microscopy. Methods for analysing materials through these microscopy techniques are well known in the art and will become apparent to the skilled person.

All values of potential given herein are, unless otherwise stated, expressed over a reference electrode of Ag/AgCl.

As mentioned above, a first aspect of the invention relates to a method for the preparation of a boron-doped carbon nanodot material as defined above. Said method allows preparing a material comprising in particular free amine end groups suitable for forming diazonium reactive groups at the outer part of the carbon nanodot material. The presence of accessible diazonium group at the outer part of a carbon nanodot allows grafting the nanodot material on the surface of an electrode material.

In a preferred embodiment of the first aspect of the invention, the alpha amino acid compound of the aqueous solution provided in step (i) is selected from the group consisting of histidine, arginine, alanine, isoleucine, cysteine, aspartic acid, leucine, glutamine, asparagine, lysine, glycine, glutamic acid, methionine, proline, serine, phenylalanine, tyrosine, threonine, tryptophan and valine. Said amino acid may be in the (L) or (D) configuration, or may exist as a mixture of (L) and (D) isomers. Preferably, the alpha amino acid is in the (L) configuration.

In a more preferred embodiment of the first aspect of the invention, the alpha amino acid compound of the aqueous solution provided in step (i) is selected from the group consisting of histidine, arginine and asparagine. Even more preferably, the alpha amino acid compound of the aqueous solution provided in step (i) is arginine, particularly, it is (L)-arginine.

The aqueous solution provided in step (i) also comprises a polyamine compound for forming carbon nanodots having amino end groups. Such polyamine compounds are known in the art and will become apparent to the skilled person. Suitable polyamine compounds for forming carbon nanodots having amino end groups by hydrothermal synthesis include diaminobenzene, triaminobenzene, hydrocarbon compounds-such as alkanes and alkenes, substituted with a plurality of amine groups and a compound of formula $NR^1R^2R^3$, wherein each of $R^1$, $R^2$ and $R^3$ is hydrogen or a $(C_1-C_6)$alkyl optionally substituted at any available position with a group of formula $NR^4R^5$ wherein each of $R^4$ and $R^5$ is hydrogen or

a (C$_1$-C$_6$)alkyl substituted at any available position with an amino group and provided that at least one of R$^1$, R$^2$ and R$^3$ is a (C$_1$-C$_6$)alkyl substituted at any available position with a group of formula NR$^4$R$^5$.

In a more preferred embodiment of the first aspect of the invention, the polyamine compounds for forming carbon nanodots having amino end groups comprised in the aqueous mixture provided in step (i) is selected from the group consisting of diaminobenzene, triaminobenzene, hydrocarbon compounds -such as alkanes and alkenes, substituted with a plurality of amine groups and a compound of formula NR$^1$R$^2$R$^3$, wherein each of R$^1$, R$^2$ and R$^3$ is hydrogen or a (C$_1$-C$_6$)alkyl optionally substituted at any available position with an amino group and provided that at least one of R$^1$, R$^2$ and R$^3$ is a (C$_1$-C$_6$)alkyl substituted at any available position with an amino group.

In a more preferred embodiment of the first aspect of the invention, the polyamine compound for forming carbon nanodots having amino end groups comprised in the aqueous mixture provided in step (i) is a compound of formula NR$^1$R$^2$R$^3$, wherein each of R$^1$, R$^2$ and R$^3$ is hydrogen or a (C$_1$-C$_6$)alkyl optionally substituted at any available position with an amino group and provided that at least one, preferably two, of R$^1$, R$^2$ and R$^3$ is a (C$_1$-C$_6$)alkyl substituted at any available position with an amino group.

In an even more preferred embodiment of the first aspect of the invention, the polyamine compound for forming carbon nanodots having amino end groups comprised in the aqueous mixture provided in step (i) is 3,3'-diamino-N-methyldipropylamine.

Thus, in a particular embodiment of the first aspect of the invention, the aqueous mixture provided in step (i) comprises arginine as alpha amino acid and 3,3'-diamino-N-methyldipropylamine as polyamine compound.

In a more particular embodiment of the first aspect of the invention, the aqueous composition provided in step (i) consists essentially of an alpha amino acid, boric acid and a polyamine compound for forming carbon nanodots having amino end groups, wherein the molar ratio of alpha amino acid to boric acid is 2:1, the molar ratio of alpha amino acid to primary amine groups in the polyamine compound is essentially 1:2 and the concentration of alpha amino acid is comprised between 2 mM and 6 mM.

In a more particular embodiment of the first aspect of the invention, the aqueous composition provided in step (i) consists essentially of arginine, boric acid and a polyamine compound for forming carbon nanodots having amino end groups, wherein the molar ratio of arginine to boric acid is 2:1, the molar ratio of arginine to primary amine groups in the polyamine compound is essentially 1:2 and the concentration of arginine is comprised between 2 mM and 6 mM.

In a more particular embodiment of the first aspect of the invention, the aqueous composition provided in step (i) consists essentially of arginine, boric acid and 3,3'-diamino-N-methyldipropylamine, wherein the molar ratio of arginine to boric acid is 2:1, the molar ratio of arginine to 3,3'-diamino-N-methyldipropylamine is essentially 1:1 and the concentration of arginine is comprised between 2 mM and 6 mM.

In a more particular embodiment of the first aspect of the invention, the aqueous composition provided in step (i) is one wherein the concentration of the alpha amino acid is 4 mM.

In a more particular embodiment of the first aspect of the invention, the aqueous composition provided in step (i) consists essentially of an alpha amino acid, boric acid and a polyamine compound for forming carbon nanodots having amino end groups, wherein the molar ratio of alpha amino acid to boric acid is 2:1, the molar ratio of alpha amino acid to primary amine groups in the polyamine compound is essentially 1:2 and the concentration of alpha amino acid is 4 mM.

In a more particular embodiment of the first aspect of the invention, the aqueous composition provided in step (i) consists essentially of arginine, boric acid and a polyamine compound for forming carbon nanodots having amino end groups, wherein the molar ratio of arginine to boric acid is 2:1, the molar ratio of arginine to primary amine groups in the polyamine compound is essentially 1:2 and the concentration of arginine is 4 mM.

In a more particular embodiment of the first aspect of the invention, the aqueous composition provided in step (i) consists essentially of arginine, boric acid and 3,3'-diamino-N-methyldipropylamine, wherein the molar ratio of arginine to boric acid is 2:1, the molar ratio of arginine to 3,3'-diamino-N-methyldipropylamine is essentially 1:1 and the concentration of arginine is 4 mM.

In a more particular embodiment of the first aspect of the invention, the heating step (ii) is carried out at a temperature of 235 °C.

In a more particular embodiment of the first aspect of the invention, the heating step (ii) is carried out at a pressure of between 1 bar and 20 bars.

In a more particular embodiment of the first aspect of the invention, the heating step (ii) is carried out for a reaction time between 150 and 200 seconds.

In a more particular embodiment of the first aspect of the invention, the heating step (ii) is carried out under microwave irradiation.

In a more particular embodiment of the first aspect of the invention, the heating step (ii) is carried out under microwave irradiation at a temperature of 235 °C, at a pressure of between 1 bar and 20 bars and for a reaction time between 150 and 200 seconds.

In a more particular embodiment of the first aspect of the invention, the method of preparation of boron-doped carbon nanodots further comprises the steps of:

    (iii) diluting the product resulting from step (ii) in water;
    (iv) removing solid particles having an average size higher than 100 nm from the product resulting from step (iii); so as to produce a solid fraction consisting of said solid particles and a liquid fraction comprising the boron-doped carbon nanodot material; and

(v) removing the suspended colloidal particles from the liquid fraction resulting from step (iv).

In a more particular embodiment of the first aspect of the invention, step (iii) comprises diluting the product resulting from step (ii) in water by a factor comprised from 50 to 200, preferably by a factor of 100.

In a more particular embodiment of the first aspect of the invention, step (iv) is carried out by filtration by means of a filter having pores of 100 nm size.

In a more particular embodiment of the first aspect of the invention, step (v) is carried out by centrifugation or dialysis. Preferably, it is carried out by dialysis.

The method of the first aspect of the invention allows preparing a boron-doped carbon nanodot material that constitutes the second aspect of the invention, as defined above.

In a preferred embodiment of the second aspect of the invention, the product is obtainable by the method as defined in any of the preferred and particular embodiments defined above for the first aspect of the invention.

As defined above, the invention relates in a third aspect to a boron-doped carbon nanodot material having free amine end groups for forming diazonium end groups characterized in that:

(i) said material exhibits a fluorescence emission peak at about 360 nm when irradiated with light of a wavelength of about 310 nm; and/or

(ii) 100 moles of said material substantially consist of from 40 to 50 moles of carbon atoms, from 5 to 15 moles of hydrogen atoms, from 15 to 25 moles of nitrogen atoms and from 10 to 40 moles of oxygen and/or boron atoms; and/or

(vi) said material exhibits infrared absorption peaks at one or more wavelengths selected from the group consisting of 3480 $cm^{-1}$, 2950 $cm^{-1}$, 1715 $cm^{-1}$, 1450 $cm^{-1}$, 1377 $cm^{-1}$, 1383 $cm^{-1}$ and 801 $cm^{-1}$; and/or

(vii) said material has an average particle size of between 10 and 50 nm as measured by dynamic light scattering; and/or

(viii) said material exhibits a zeta potential lower than -5 mV at pH values higher than 6 at a concentration of boron-doped carbon nanodot material in water of 1.30 mg per mL.

The presence of free amine end groups suitable for forming diazonium salts in the boron doped carbon nanodot material advantageously allows the grafting of said materials on surfaces by chemical reduction or electrochemical reduction in a straightforward manner.

In a preferred embodiment, the boron-doped carbon nanodot material of the third aspect of the invention is characterized in that it combines two or more, preferably four or more, and more preferably all, of the features (i) to (viii) defined above. This material advantageously allows preparing electrodes with improved capacitance, as further disclosed below.

In a preferred embodiment, the boron-doped carbon nanodot material of the third aspect of the invention is characterized in that its UV-Vis absorption spectrum is substantially the UV-Vis absorption spectrum shown in Fig. 1(A).

In a preferred embodiment, the boron-doped carbon nanodot material of the third aspect of the invention is characterized in that its fluorescence emission spectrum when the boron-doped carbon nanodot material is irradiated with light at a wavelength of 310 nm is substantially the fluorescence emission spectrum of Figure 1(B).

In a preferred embodiment, the boron-doped carbon nanodot material of the third aspect of the invention is characterized in that its FT-IR absorption spectrum is substantially the FT-IR absorption spectrum of Figure 1(C).

In a preferred embodiment, the boron-doped carbon nanodot material of the third aspect of the invention is characterized in that 100 moles of said material substantially consist of about 46.6 moles of carbon atoms, about 9.2 moles of hydrogen atoms, about 19.3 moles of nitrogen atoms and about 24.9 moles of oxygen and/or boron atoms.

As defined above, the fourth aspect of the invention relates to an aqueous composition comprising the boron doped carbon nanodot material of the third aspect of the invention.

In a preferred embodiment of the fourth aspect of the invention, said aqueous composition consists of a water solution of the boron doped carbon nanodot material of the third aspect of the invention.

In a preferred embodiment of the fourth aspect of the invention, the boron doped carbon nanodot material is in a concentration of between 1 and 3 gram per liter of solvent, said solvent being preferably water.

As defined above, the fifth aspect of the invention relates to a method for the preparation of an electrode comprising the steps of:

(i) submitting a product as defined in the second aspect of the invention or an aqueous composition as defined in the fourth aspect of the invention to reaction conditions suitable for converting at least one amine group of the boron-doped carbon nanodot material in a diazonium group;

(ii) providing an electrode support consisting essentially of a carbon material;

(iii) contacting the electrode support provided in step (ii) with the product or composition provided in step (i) while applying a potential being equal to or inferior to -0.7 V, so as to promote the grafting of the boron-doped carbon nanodot material comprised in the mixture resulting from step (i) on the surface of the electrode support such that the grafted boron-doped carbon nanodot material has a height inferior to 2 nm as measured by atomic force microscopy.

In preferred embodiments of the fifth aspect of the invention, the product submitted to reaction conditions suitable for converting at least one amine group of the boron-doped carbon nanodot material in a diazonium group in step (i) is as defined in any of the particular and preferred embodiments of the second or fourth aspect of the invention as defined above.

Suitable reaction conditions for converting at least one amine group of the boron-doped carbon nanodot material in a diazonium group are known in the art and will become apparent to the skilled person upon reduction to practice of the invention. Particularly preferred conditions comprise contacting the product as defined in the second aspect of the invention or an aqueous composition as defined in the fourth aspect of the invention with an alkali salt of nitrite, such as sodium nitrite, in the presence of an acid that is preferably hydrochloric acid.

In preferred embodiments of the fifth aspect of the invention, the carbon material making essentially the electrode support provided in step (ii) is selected from the group consisting of graphite, graphene, graphene oxides and reduced graphene oxide. More particularly, said carbon material consists essentially of graphite. Even more particularly, said carbon material consists essentially of highly ordered pyrolytic graphite (HOPG).

As defined above, step (iii) of the method of the fifth aspect of the invention comprises contacting the electrode support provided in step (ii) with the product or composition provided in step (i) while applying a potential being equal to or inferior to - 0.7 V, so as to promote the grafting of the boron-doped carbon nanodot material comprised in the mixture resulting from step (i) on the surface of the electrode support such that the grafted boron-doped carbon nanodot material has a height inferior to 2 nm as measured by atomic force microscopy.

The application of a potential equal to or inferior to -0.7 V is necessary to promote the reduction of the diazonium groups on the product of step (i) of the method of the fifth aspect of the invention and to promote the grafting of the boron-doped carbon nanodot to the surface of the electrode. Said potential must be applied during a sufficient period of time to allow for the formation of a grafted boron-doped carbon nanodot material having a height inferior to 2 nm as measured by atomic force microscopy. At the beginning of the electrografting process, the height as measured by atomic force microscopy is typically above 2 nm and reaches the value of 2 nm or less once the electrografting process is terminated and hexagonal aggregates are formed. Thus, it is necessary to apply said potential for a sufficient amount of time in order to cover substantially the whole surface of the electrode material with boron-doped carbon nanodot forming hexagonal aggregates.

Several methods for applying said potential may be employed. In an embodiment, it is contemplated that the potential is applied by performing potentiometric cycles between 0.0 V and -0.8 V at a scan rate comprised between 10 mV/s and 250 mV/s, preferably at a scan rate of 100 mV/s. When a scan rate of 100 mV/s is employed, it is preferred that at least 40 potentiometric cycles between 0.0 V and -0.8 V are carried out. Preferably, the potential is applied by submitting the electrode support of step (ii) in contact with the solution produced in step (i) to a number comprised between 40 and 100 of potentiometric cycles between 0.0 V and -0.8 V that are carried out at a scan rate of 100 mV/s. More preferably, the potential is applied by submitting the electrode support of step (ii) in contact with the solution produced in step (i) to a number of comprised between 40 and 60 potentiometric cycles between 0.0 V and -0.8 V that are carried out at a scan rate of 100 mV/s. This method is preferred as it advantageously allows forming well-defined hexagonal nanostructures, as observed by microscopy.

In an embodiment, it is contemplated that the potential is applied by applying a potential equal to or inferior to -0.7 V for a period of time of at least 800 seconds. In a preferred embodiment, it is contemplated applying a potential equal to -0.7 V for a period of time of between 800 and 1500 seconds; preferably of 800 seconds.

As mentioned above, the progress of the grafting progress can be monitored by measuring the height of the grafted material by atomic force microscopy. It is considered that the grafting process is completed when said height is inferior to 2 nm.

As defined above, the sixth aspect of the invention relates to an electrode obtainable by the method of the fifth aspect of the invention.

Thus, preferred embodiments of the sixth aspect of the invention relate to an electrode obtainable by the method of any of the particular and preferred embodiments of the fifth aspect of the invention.

The electrode of the invention is also characterized for combining several features. Thus, the seventh aspect of the invention relates to an electrode comprising a boron-doped carbon nanodot material grafted on a carbon material characterized in that:

(i) said electrode exhibits Raman absorption peaks at one or more wavelengths selected from the group consisting of 500 $cm^{-1}$, 1230 $cm^{-1}$, 2911 $cm^{-1}$ and 2965 $cm^{-1}$; and/or
(ii) said electrode exhibits a charge resistance for electron transfer of about 240 $\Omega$ as measured by electrochemical impedance spectroscopy; and/or
(iii) said electrode exhibits a reduction potential of about 0.1 V and an oxidation potential of about 0.4 V as measured by cyclic voltammetry using a Ag/Ag-Cl reference electrode and a platinum wire counter electrode at 10 mV/s scan rate in 0.1 M phosphate buffer of pH 7.4 containing 0.1 M KCl; and/or

(iv) said material exhibits a capacitance higher than 1000 $\mu$F per cm$^2$ at a scan rate of 0.005 V/s as measured by cyclic voltammetry.

The presence of boron doped carbon nanodot material grafted on the surface advantageously provides an electrode having improved conductivity and capacitance.

In a preferred embodiment, the electrode of the seventh aspect of the invention is characterized in that it combines two or more, and more preferably all, of the features (i) to (iv) defined above.

In preferred embodiments, the electrode material of the seventh aspect of the invention is characterized in that it has a microscopic structure substantially as shown in any one of the Figures 7(A), 7(B), 7(C), 8(B), 9(A), 9(B), 9(C), 10(A), 10(B) and 12(A), as observed by atomic force microscopy.

In preferred embodiments, the electrode material of the seventh aspect of the invention is characterized in that it has a XPS spectrum for B 1s and N 1s substantially as shown in Figure 14 (bottom).

In preferred embodiments, the electrode material of the seventh aspect of the invention is characterized in that its Raman spectrum is substantially as shown in Figure 15.

In preferred embodiments, the electrode material of the seventh aspect of the invention is characterized in that its potentiometric cyclic voltammetry curve is substantially as shown in Figure 17, in particular when measured at 0.01 V/s scan rate in 1.0 mM $K_4[Fe(CN)_6]$ in 0.1 M phosphate buffer pH 7.4 containing 0.1 M KCl.

In preferred embodiments, the electrode material of the seventh aspect of the invention is characterized in that it exhibits a capacitance higher than 200 $\mu$F per cm$^2$ at a scan rate of 0.1 V/s as measured by cyclic voltammetry. In further preferred embodiments, the electrode material of the seventh aspect of the invention is characterized in that it exhibits a capacitance higher than 100 $\mu$F per cm$^2$ at a scan rate of 0.5 V/s as measured by cyclic voltammetry.

Values of capacitance disclosed in the description and in the claims may be measured using cyclic voltammetry between -1.0 V and 1.0 V at 100 mV/s scan rate in 0.5 M $H_2SO_4$ using a two-electrodes configuration and as further detailed in Example 2 below.

An advantage of the electrode of the invention is that it exhibits a high capacitance, which means that the electrode also benefits from a large electrochemical surface area. Thus, the electrode materials of the invention may be useful in a broad range of applications, such as electrocatalysis, capacitors and electrochemiluminescent sensors.

As defined above, the eighth aspect of the invention relates to the use of an electrode as defined in the sixth or seventh aspect of the invention as capacitor, or as electrocatalyst, or as electrochemiluminescent electrode.

Throughout the description and claims the word "comprises" and variations of the word, are not intended to exclude other technical features, additives, components or steps. Furthermore, the word "comprise" encompasses the cases of "consist of" and "consists essentially of". Additional objects, advantages and features of the invention will become apparent to those skilled in the art upon examination of the description or may be learned by practice of the invention. The following examples are provided by way of illustration, and they are not intended to be limiting of the present invention.

## EXAMPLES

*List of abbreviations*

B-CND: boron-nitrogen doped carbon nanodots
HOPG: highly ordered pyrolytic graphite
XPS: X-Ray photoelectron spectroscopy
EIS: Electrochemical Impedance Spectroscopy
ECL: Electrochemoluminescence

*General considerations*

L-arginine, 3,3'-diamino-N-methyldipropylamine, boric acid, $[Ru(bpy)_3]^{2+}$, potassium hexacyanoferrate(III), potassium hexacyanoferrate(II) trihydrate, potassium chloride and sodium phosphate dibasic $\geq$99%, sodium were purchased from Sigma-Aldrich-Merck. Sodium nitrite was supplied by Riedel-de-Haen. 37% (w/w) hydrochloric acid was purchased from Scharlau. Dialysis membrane tubing cutoff in the range of (0.1-0.5) kDa was purchased from Spectrum Laboratories. All solutions were prepared in water purified in a Millipore Milli-Q system.

Reactor microwave CEM Discover microwave system (200 W, Matthews (NC), USA) was employed to synthesize the solution of boron-doped carbon nanodots.

UV-vis absorption and fluorescence spectra were measured using UV1700 series spectrometer (Shimadzu Corp.) and the photoluminescence measurements were carried out in a Cary Eclipse Varian spectrofluorophotometer. The measurements were performed in aqueous solutions using a quartz cell with 1.0 cm optical path.

Fourier transform infrared (FTIR) spectra were recorded from KBr pressed pellets using a Brucker IFS66v spectrometer.

Dynamic light scattering (DLS) Malvern Zetasizer Nano ZS was used to measure the size of particles of B-CND.

Zeta potential equipment Zetasizer Nano ZS instrument (Malvern Instrument Ltd., Grovewood, Worcestershire, UK) was used to measure surface charge of B-CND. Phosphate buffer solution at 0.1M concentration was used for measurements at pH values of 6.0, 7.0, 7.4 and 8.0, using sulfuric acid and sodium hydroxide to adjust pH. A buffer of acetic acid/sodium acetate at 0.1M concentration was used for measurements at pH 4.0. A buffer of boric acid/sodium tetraborate at 0.1M concentration was used for measurements at pH 10.0.

Electrochemical measurements were performed with a Metrohm Autolab PGSTAT128N and PGSTAT30 analyzer controlled by NOVA and GPES 4.9 software, respectively. Experiments were run in a three-electrode glass cell using an Ag/AgCl reference electrode and a platinum wire counter electrode. The electrochemical measurements for electrode characterization were performed in a home-made Teflon cell where the exposed area of HOPG electrode is controlled (diameter of 4 mm). For supercapacitor characterization, the charge-discharge curves and cyclic voltammetry for capacitance measurements were obtained using a two-electrode configuration, employing two identical HOPG plates, with the same modification process.

Atomic Force Microscopy (AFM) images were performed with an Agilent 5500 microscope and Olympus cantilevers (RC800PSA, 200_20 mm) operating in contact mode in air.

X-ray Photoelectron Spectroscopy (XPS) analysis of the electrodes surface samples was carried out with a Phoibos 150 MCD spectrometer equipped with hemispherical electron analyzer, and using an Al K$\alpha$ X-ray source (1486.7 eV) with an aperture of 7 mm x20 mm. The base pressure in the ultra-high vacuum chamber was $2\times10^{-9}$ mbar, and the experiments were carried out a room temperature. A 30 eV pass energy was applied for taking the overview sample, whereas 20 eV pass energy was applied for the analysis of the following core level spectra: O(1s), C(1s), N(1s) and B(1s). XPS spectra regions were fitted and deconvoluted using the fitt-xps software.

The Raman equipment employed was the confocal Bruker Senterra with a resolution of 3-5 cm$^{-1}$, a laser excitation wavelength of 532 nm and a 50x lens Olympus MPlan Achromat (numerical aperture = 0.75).

Electrochemical impedance spectroscopy (EIS) experiments were performed using electrochemical probe 1.0 mM $K_4[Fe(CN)]_6$ in 0.1 M phospahte buffer (pH 7.4) containing 0.1 M KCl. Potential applied was 0.25 V. Impedance measurements were recorded with a sinusoidal potential modulation of $\pm10$ mV in amplitude superimposed onto the formal potential of the redox probe. Data obtained from EIS experiments were analysed by fitting the experimental data to an electrical equivalent circuit model using the software FRA 4.9.

Electrochemoluminescence (ECL) experiments were performed on screen carbon electrode using a bipotentiostat/galvanostat ($\pm4$ V DC potential range, $\pm40$ mA maximum measurable current) combined with a Si-Photodiode integrated in a electrochemiluminiscence cell from DropSens-Metrohm using $[Ru(bpy)_3]^{2+}$ 2.0 mM in phosphate buffer 0.1M, pH=8.0.

Example 1: Synthesis of carbon nanodots Boron-doped (B-CND)

A mixture of 87 mg L-arginine, 15.4 mg Boric Acid ($H_3BO_3$), 86 $\mu$L 3,3'-diamino-*N*-methyldipropylamine and 100 $\mu$L Milli-Q water was irradiated in a microwave system (CEM Discover ®) at a constant temperature of 235 °C and a maximum pressure of 20 bar during 180 s. Then, the yellow solid obtained was dissolved in 10 mL of ultra-pure water and filtered using 0.1 $\mu$m porous filter. The suspension was dialyzed in a 0.1-0.5 kDa dialysis membrane for 1 week.

The elemental analysis of the synthetized B-CND was carried out by drying the B-CNDs in an oven at 70 °C and performing conventional elemental analysis on the resulting yellow solid. Elemental analysis indicates the following contents: carbon 46.6 $\pm$ 0.5%; hydrogen 9.2 $\pm$ 0.1%; nitrogen 19.3 $\pm$ 0.1% and oxygen and Boron 24.9 $\pm$ 0.7% (calculated by difference). By means of comparison, a carbon nanodot material prepared as defined above, except that no boric acid was present in the reaction mixture, exhibits an elemental analysis indicating the following contents: %C: 50.29, %H: 9.04, %N: 21.93, %O: 18.74 (calculated by difference).

The B-CND material prepared in Example 1 is characterized by the UV-Vis spectrum shown in Figure 1 (A), the fluorescence emission spectrum shown in Figure 1 (B) when the aqueous solution resulting from Example 1 is irradiated with light at a wavelength of 310 nm, and the FT-IR spectrum shown in Figure 1 (C).

Figure 2 (A) shows the distribution of particle size of the B-CND material prepared according to the present Example as measured by Dynamic Light Scattering. Figure 2 (B) shows the evolution of the zeta potential of the aqueous solution of the B-CND material prepared according to the present Example in function of the pH of the aqueous solution. The zeta potential value measured at different pH values (Figure 2 (B)) suggests the presence of negative charges at the B-CND surface a pH higher than pH=5.0 in the form of carboxylate groups.

Example 2: Preparation of electrodes by electrografting of B-CND

In a first step, the free amine groups of the B-CND material prepared in Example 1 were submitted to a diazotation step. B-CND diazotation was performed in an ice bath by mixing 1.0 mL of a solution containing B-CND in 0.5 M HCl and 1.0 mL of 14.5 mM $NaNO_2$ during 1h.

Highly oriented pyrolytic graphite (HOPG) was provided by Goodfellow. It was exfoliated with adhesive tape to obtain a renewed and a flat surface and it was connected to a copper wire, thus providing an electrode support. Then, the electrode support was immersed into an electrochemical cell as working electrode together with a platinum wire as counter electrode and a Ag/AgCl

as reference electrode in 2.0 mL of a solution containing B-CND diazotized. The electrografting process was made by applying consecutive cyclic voltammograms from 0.0 V to -0.8 V at 100 mV/s scan rate. Afterwards, the electrode was rinsed with ultrapure water. The numbers of electrochemical cycles studied were 10, 25, 32, 40, 50 and 60, as further discussed below.

The Figure 3 (A) shows electrochemical reduction of diazotized B-CND on HOPG monitored by cyclic voltammetry. Voltammograms show the characteristic irreversible reduction process attributed to the reduction of the diazonium salt on HOPG and how, as the electrode becomes coated from the second cycle, the signal current intensity decreases. These results confirm that the B-CND contain on their surface aromatic amines and can be immobilized by electrografting process on HOPG. In addition, control experiments with non-diazotized B-CND were performed and reveals the absence of the irreversible reduction process (Figure 3 (B)). This result shows the success of the electrografting of the diaotized B-CND on HOPG.

*Electrografting with 10 electrochemical cycles between 0.0 V and -0.8 V (comparative example)*

The electrografting procedure described above was carried out applying 10 electrochemical cycles between 0.0 V and -0.8 V. Figure 4 shows different AFM pictures of the resulting electrode. As can be seen on Figure 4, the surface is decorated with circular, bead-like, nanostructures and in the AFM image can be distinguished different planes of HOPG, revealing that the surface is not fully covered. Moreover, B-CNDs are not randomly distributed over the surface, B-CNDs tend to approach and they are organized following a specific distribution. The height of the electrografted B-CND after 10 electrochemical cycles, as measured by AFM, is about 7 nm. This corresponds to the height of deposited carbon nanodot material prepared according to Example 2 using a carbon nanodot material prepared according to Example 1, except for the absence of boric acid in the reaction mixture.

*Electrografting with 25 electrochemical cycles between 0.0 V and -0.8 V (comparative example)*

The electrografting procedure described above was carried out applying 25 electrochemical cycles between 0.0 V and -0.8 V. Figure 5 shows different AFM pictures of the resulting electrode. As can be seen on Figure 5, the surface is decorated with circular nanostructures and in the AFM image can be distinguished different planes of HOPG, revealing that the surface is not fully covered. Moreover, B-CNDs are not randomly distributed over the surface, as B-CNDs tend to approach and they are organized following a specific distribution. The height of the electrografted B-CND after 25 electrochemical cycles, as measured by AFM, is about 5 nm.

Thus, the height of the deposited material decreases while the electrografting by reduction of the diazotized B-CND progresses. These results suggest the formation of aggregates of B-CND on the surface of HOPG.

*Electrografting with 32 electrochemical cycles between 0.0 V and -0.8 V (comparative example)*

The electrografting procedure described above was carried out applying 32 electrochemical cycles between 0.0 V and -0.8 V. Figure 6 shows different AFM pictures of the resulting electrode. As can be seen on Figure 6, B-CND are getting closer to each other and are organized following a specific distribution, such that B-CNDs share a side of a hypothetical hexagon. The height of the electrografted B-CND after 32 electrochemical cycles, as measured by AFM, is about 4 nm. Thus, the height of the deposited material decreases while the electrografting by reduction of the diazotized B-CND progresses. These results suggest the formation of hexagonal aggregates of B-CND on the surface of HOPG.

*Electrografting with 40 electrochemical cycles between 0.0 V and -0.8 V*

The electrografting procedure described above was carried out applying 40 electrochemical cycles between 0.0 V and -0.8 V. Figure 7 shows different AFM pictures of the resulting electrode. As can be seen on Figure 7, B-CNDs cover the whole surface of the electrode and are organized following a specific distribution, such that B-CNDs share a side of a hypothetical hexagon. The height of the electrografted B-CND after 40 electrochemical cycles, as measured by AFM, is about 1.5 nm. These results suggest the formation of hexagonal aggregates of B-CND on the surface of HOPG.

*Electrografting with 50 electrochemical cycles between 0.0 V and -0.8 V*

The electrografting procedure described above was carried out applying 50 electrochemical cycles between 0.0 V and -0.8 V. Figure 9 shows different AFM pictures of the resulting electrode. As can be seen on Figure 9, B-CNDs cover the whole surface of the electrode and are organized following a specific distribution, such that B-CNDs share a side of a hypothetical hexagon. The height of the electrografted B-CND after 50 electrochemical cycles, as measured by AFM, is about 1.6 nm. Thus, the height of the electrografted B-CND after 40 electrochemical cycles remains constant while the system is submitted to an increasing number of electrochemical cycles, thus suggesting that the grafting process is at a stable equilibrium. AFM studies also show that the formed hexagonal structures present a hollow structure, such that a porous surface from bottom to top has been generated with an approximate height of 1.5 nm, this being of great interest for different types of applications such as for the development of devices for energy storage and as an electrochemical platform for (bio)electrochemical sensor applications.

Surface of HOPG before and after being electrografted with B-CND are shown in Figure 8 (A) and (B) respectively, as studied by means of AFM. AFM contact-mode image shows that the surface in Figure 8 (B) is mostly covered with hexagonal structures that are interconnected and not isolated. Figure 8 (C) shows the surface of HOPG submitted to electrografting of CND prepared according to Example 1, except for the absence of boric acid in the reaction mixture. A significant clear difference between Figure 8 (B) and 8 (C) is observed, globular and almost spherical nanostructures are observed on HOPG in the case of Figure 8 (C). Thus, the presence of boron in the carbon nanodot materials appears to be essential to the generation of hexagon-shaped nanostructures on the surface of HOPG by electrografting. The topographic profiles between Figures 8 (B) and (C) corroborate the difference. The inset of Figure 8 (B) shows that the height of hexagons formed by electrografting of B-CNDs is 1.4 nm compared with the bare HOPG. In contrast, the inset of Figure 8 (C) shows that the height of spherical structures formed by electrografting of CNDs is of about 5 nm compared with the bare HOPG.

A comparative Example was further carried out following the procedure described herein with an application of 50 electrochemical cycles, except that the B-CND were not diazotized prior to being submitted to electrografting (i.e. electrografting carried out in absence of sodium nitrite or with no previous treatment with sodium nitrite). The AFM images shown in Figure 13 resulting from this comparative Example show that the grafted B-CND materials present a height of more than 10 nm and that the hexagonal shapes are not formed. This Example shows that the presence of a treatment with sodium nitrite prior to or during the electrografting process is essential to the formation of hexagonal-shaped nanostructures having a height below 2 nm.

It is also noted that the hexagonal electrografted B-CND nanostructures have been successfully prepared following the present procedure, except that the HOPG carbon surface was replaced with a screen printed electrode. The formation of hexagonal nanostructures was confirmed by FE-SEM microscopy.

*Electrografting with 60 electrochemical cycles between 0.0 V and -0.8 V*

The electrografting procedure described above was carried out applying 60 electrochemical cycles between 0.0 V and -0.8 V. Figure 10 shows different AFM pictures of the resulting electrode. As can be seen on Figure 10, B-CNDs cover the whole surface of the electrode and are organized following a specific distribution, such that B-CNDs share a side of a hypothetical hexagon. The height of the electrografted B-CND after 60 electrochemical cycles, as measured by AFM, is about 1.5 nm. These results suggest the formation of hexagonal aggregates of B-CND on the surface of HOPG and that despite more reductive electrochemical cycles are applied, B-CNDs do not electrograft on top of each other to produce a multi-layered material. The formation of hexagonal nanostructures having a height of 1.5 nm thus appears to be favored in these conditions.

*Electrografting with a constant potential of -0.6 V (comparative Example) or - 0.7 V*

The electrografting procedure described above was carried out by replacing the electrochemical cycles with the application of a constant potential of - 0.6 V (Figure 11) or - 0.7 V (Figure 12) during 800 seconds, which is the time necessary to perform 50 electrochemical cycles as described above. AFM images of the resulting electrodes as shown in Figure 11 show that large aggregates are formed over a sublayer of smaller globular aggregates of B-CND with height 7 nm, approximately. Nevertheless, when the potential used is -0.7 V, the AFM image of Figure 12 shows that hexagonal structures have been generated on HOPG with similar characteristic height of about 1.6 nm to those obtained previously by the application of at least 40 electrochemical cycles as defined above.

*Deposition of B-CND by drop casting (Comparative Example)*

B-CND prepared according to the method of Example 1 were directly deposited by drop-casting on the surface of HOPG support as prepared according to Example 2. AFM images of the resulting material (not shown) show an aggregate of B-CND having a maximal height of about 22 nm and spherical shape. When the drop-casting is carried out with diazotized B-CND material, AFM images of the resulting material (not shown) show a spherical non-hexagonal aggregate of B-CND having a maximal height of about 2.5 nm.

According to this comparative Example, it is concluded that the specific hexagonal-shaped material of Example 2 is preferably obtained by the means of an electrochemical grafting process, such as the application of a certain number of electrochemical cycles or the application of a constant potential.

*Characterization of the electrografted B-CND material having hexagonal shape*

In order to obtain information on the chemical characterization of the hexagonal structure formation on the surface, XPS analysis of B-CND as prepared in Example 1 and untreated with sodium nitrite deposited directly by drop casting on HOPG surface was carried out and compared with XPS analysis of B-CND as prepared in Example 2 by electrografting (50 cycles) on HOPG surface. The drop-casting procedure depositing 10 μL of the corresponding suspension of B-CND (with no dilution) over the electrode surface and let dried under room conditions. Figure 14 shows the XPS spectra of N(1s) and B(1s) demonstrating the presence of these two elements in both electrode samples. The best fit of the N(1s) core level shows three contributions at binding energies of 399.1-399.5 eV, 400.7-401.0 eV and 402.3-402.4 eV which are assigned to $NH_2$ nitrogen and imines, NH and nitrides/nitriles, and finally ammonium salts and azides. Although both samples present similar components, the spectral profile shows a remarkable difference due to the related ratio components, which are 65.3%, 23.1% and 11.6% respectively for the drop casted sample and 42.5%, 41.6% and 15.9% for the electrografted sample. Remarkably, for the nitride functional group, the first component decreases and the second component increases for the electrografted sample compared with the dropcasted sample. In addition, the B(1s) core level peak presents three similar components at 187.3 assigned to boron carbide or boride, a second one at 189.3 eV assigned to nitrides and B-N bonds, and the third one assigned to (B-O, B-OH, B-C). The main difference in XPS spectra is the increase of the nitride component for the electrografted sample. The detailed deconvolution of both elements, nitrogen and boron, suggests the formation of boron nitride species for the electrografting process, which would be related to the presence of the hexagonal structure.

The electrografted B-CND material as prepared according to Example 2 after 50 electrochemical cycles carried out in the presence of sodium nitrite was further studied by Raman spectroscopy. Figure 15 shows that the electrografted B-CND material exhibits an intense band at 500 cm$^{-1}$ and another less intense band at 1230 cm$^{-1}$ associated with the effect of doping with boron on the CND. These bands are not observed for HOPG. These bands are associated with two maxima in the phonon density of states and are typical of a highly boron-doped carbon dots. Also, the bands located at 2900 cm$^{-1}$ that do not appear in the spectra of the bare surface of HOPG, can be assigned to the combination of the D and G bands. In both spectra, two bands also appear around 1550 cm$^{-1}$, which are attributed to the sp$^2$ carbon and it is described as G-type graphite disorder. There is also a second order 2D band present around 2700 cm$^{-1}$.

The electrochemical properties of an electrode prepared by electrografting diazotized B-CND on HOPG via 50 electrochemical cycles as defined above have also been studied. In particular, the electrochemical impedance spectroscopy (EIS) of said electrode has been compared with the one of bare HOPG. Figure 16 shows Nyquist plot with a sinusoidal wave using $K_4[Fe(CN)_6]$ as an electrochemical probe for these systems. The charge resistance for electron transfer ($R_{et}$) calculated was 800 Ω for naked HOPG and 240 Ω for HOPG with hexagonal structures of B-CNDs (i.e. about 3.3-fold reduction). The generation of these hexagonal nanostructures produces a considerable 3-fold decrease in the $R_{et}$. These results demonstrate that the conductivity of the surface decorated with B-CNDs is much higher than the conductivity of bare HOPG.

The study of the electron transfer of the redox probe $K_4[Fe(CN)_6]$ has also been carried out by cyclic voltammetry, in the absence and in the presence of the B-CND hexagonal structures. The behavior of the redox probe in the bare HOPG electrode is shown in Figure 17. It can be seen that the profile obtained is the expected one for a HOPG surface where the basal planes predominate, characterized by their low conductivity, it becomes clear that there is no quasi-reversible signal associated with the oxidation and reduction of $Fe^{2+/3+}$. In the case of cyclic voltammetry performed in the presence of B-CND hexagonal structures, it can be observed that the separation between the anodic and cathodic peaks is smaller. These results confirm that the growth of B-CND hexagonal nanostructures on the surface of HOPG considerably improves the electron transfer properties and conductivity of HOPG.

The electrochemiluminescent properties of the B-CND electrode with hexagonal nanostructures have been studied and compared with bare HOPG. Figure 18 provides evidence for a pronounced increase of electrochemiluminescence (ECL) when B-CND hexagons are developed on the surface of HOPG in presence of $[Ru(bpy)_3]^{2+}$ as luminophore. The formed B-CND hexagonal nanostructures act as co-reactant in the ECL process, thus enhancing the ECL process. These results suggest that the surfaces covered with hexagonal B-CND nanostructures as disclosed herein present a greater relative surface area due to formation of hexagonal nanostructures from bottom to top, increasing electron transfer properties, and showing a significant improvement in both electrical conductivity and electrochemoluminescent properties.

The potential of the electrode consisting of HOPG covered with hexagonal B-CND nanostructures according to the invention as supercapacitors was further evaluated by measurements of capacitance by cyclic voltammetry of charge-discharge curves using a two-electrode configuration in 0.5 M $H_2SO_4$, using two identical HOPG plates, with the same modification process, in each case. Three systems were studied: (1) bare HOPG electrode; (2) HOPG covered with carbon nanodot by electrografting according to Example 2, except that the carbon nanodot material was prepared as described in Example 1 except for the absence of boric acid (CND); (3) HOPG covered with B-CNDs having hexagonal nanostructures by electrografting according to Example 2 (B-CND). Typically, the capacitance of the supercapacitor is evaluated from the charge/discharge cycles slope, using Eq. (1):

$$C_{Total} = \frac{I}{2 \times (\frac{dV}{dt}) \times A} \text{ (1)}$$

where I is the current applied, V is the potential measured over time (t) and A is the electrode geometric area.

The capacitance of the working electrode was calculated from the corresponding voltammograms, using the following Eq. (1):

$$C_{Total} = \frac{\int_{V1}^{V2} I(V)dV}{2 \times \Delta V \times v \times A} \ (1)$$

where $C_{Total}$ is the specific capacitance exhibited by the working electrode in $\mu F/cm^2$, fI(V)dV is the area under the intensity current function between $V_2$ and $V_1$ potentials in Coulombs (C), $\Delta V$ is the potential difference between $V_2$ and $V_1$ in volts (V), v is the voltammogram scan rate in volts per second (V/s) and A is the electrode geometric area.

CV results (Figure 19) clearly show an increase of specific surface capacitance when B-CND are electrografted over HOPG if compared with the results obtained for CND electrografting modification and bare HOPG. The capacitance increase is one order of magnitude higher, which points out that the hexagonal nanostructures generate a great increase of electrochemically active surface area, improving the energy storage capacity.

This potential improvement of the properties obtained in HOPG surface due to generation on hexagons based on B-CND opens the possibility of different applications, such as electrochemiluminescent sensors, supercapacitators or electrocatalysts.

**Claims**

1. Method for the preparation of a boron-doped carbon nanodot material comprising the steps of:

   (i) providing an aqueous solution comprising an alpha amino acid, boric acid and a polyamine compound for forming carbon nanodots having amino end groups, wherein the molar ratio of alpha amino acid to boric acid is 2:1, the molar ratio of alpha amino acid to primary amine groups in the polyamine compound is essentially 1:2 and the concentration of alpha amino acid is comprised between 2 mM and 6 mM;
   (ii) heating the solution provided in step (i) in a closed vessel at a temperature of between 180 °C and 250 °C so as to avoid the evaporation of water as the solvent.

2. Method according to claim 1 wherein the heating step (ii) satisfies one or more of the following conditions (a) to (d):

   (a) the heating step is carried out at a temperature of 235 °C;
(b) the heating step is carried out at a pressure of between 1 bar and 20 bars;
(c) the reaction time is between 150 and 200 seconds;
(d) the heating step (ii) is carried out under microwave irradiation;
(e) the alpha amino acid is arginine;
(f) the polyamine compound is 3,3' diamino-*N*-methyldipropylamine;
(g) the concentration of alpha amino acid is about 4 mM.

3. Method according to any one of claims 1 to 2 further comprising the steps of:

   (iii) diluting the product resulting from step (ii) in water;
   (iv) removing solid particles having an average size higher than 100 nm from the product resulting from step (iii); so as to produce a solid fraction consisting of said solid particles and a liquid fraction comprising the boron-doped carbon nanodot material; and
   (v) removing the suspended colloidal particles from the liquid fraction resulting from step (iv).

4. Product obtainable by the method as defined in any one claims 1 to 3.

5. Boron-doped carbon nanodot material having free amine end groups for forming diazonium end groups **characterized in that**:

   (i) said material exhibits a fluorescence emission peak at about 360 nm when irradiated with light of a wavelength of about 310 nm; and/or
   (ii) 100 moles of said material substantially consist of from 40 to 50 moles of carbon atoms, from 5 to 15 moles of hydrogen atoms, from 15 to 25 moles of nitrogen atoms and from 10 to 40 moles of oxygen and/or boron atoms; and/or
   (iii) said material exhibits infrared absorption peaks at one or more wavelengths selected from the group consisting of 3480 cm$^{-1}$, 2950 cm$^{-1}$, 1715 cm$^{-1}$, 1450 cm$^{-1}$, 1377 cm$^{-1}$, 1383 cm$^{-1}$ and 801 cm$^{-1}$; and/or
   (iv) said material has an average particle size of between 10 and 50 nm as measured by dynamic light scattering; and/or
   (v) said material exhibits a zeta potential lower than -5 mV at pH values higher than 6 at a concentration of boron-doped carbon nanodot material in water of 1.30 mg per mL.

6. Aqueous composition comprising the material of claim 5.

**7.** Method for the preparation of an electrode comprising the steps of:

(i) submitting a product as defined in claim 4 or an aqueous composition as defined in claim 6 to reaction conditions suitable for converting at least one amine group of the boron-doped carbon nanodot material in a diazonium group;
(ii) providing an electrode support consisting essentially of a carbon material;
(iii) contacting the electrode support provided in step (ii) with the product or composition provided in step (i) while applying a potential being equal to or inferior to -0.7 V, so as to promote the grafting of the boron-doped carbon nanodot material comprised in the mixture resulting from step (i) on the surface of the electrode support such that the grafted boron-doped carbon nanodot material has a height inferior to 2 nm as measured by atomic force microscopy.

**8.** Method according to claim 7 wherein step (i) comprises contacting the product as defined in claim 4 or the aqueous composition as defined in claim 6 with sodium nitrite in the presence of an acid.

**9.** Method according to any one of claims 7 to 8 wherein the electrode support of step (ii) consists essentially of graphite.

**10.** Method according to any one of claims 7 to 9 wherein step (iii) comprises applying at least 40 cycles of potential cycling between 0 and -0.8 V at 100 mV/s scan rate; or, alternatively, applying a potential equal to -0.7 V for a period of time of at least 800 seconds.

**11.** Electrode obtainable according to the method of any of claims 7 to 10.

**12.** Electrode comprising a boron-doped carbon nanodot material grafted on a carbon material **characterized in that**:

(i) said electrode exhibits Raman absorption peaks at one or more wavelengths selected from the group consisting of 500 $cm^{-1}$, 1230 $cm^{-1}$, 2911 $cm^{-1}$ and 2965 $cm^{-1}$; and/or
(ii) said electrode exhibits a charge resistance for electron transfer of about 240 $\Omega$ as measured by electrochemical impedance spectroscopy; and/or
(iii) said electrode exhibits a reduction potential of about 0.1 V and an oxidation potential of about 0.4 V as measured by cyclic voltammetry using a Ag/AgCl reference electrode and a platinum wire counter electrode at 10 mV/s scan rate in 0.1 M phosphate buffer of pH 7.4 containing 0.1 M KCl; and/or

(iv) said material exhibits a capacitance higher than 1000 $\mu$F per $cm^2$ at a scan rate of 0.005 V/s as measured by cyclic voltammetry.

**13.** Use of an electrode as defined in claim 11 or in claim 12 as capacitor, or as electrocatalyst, or as electrochemiluminescent electrode.

FIG. 1

Statistics Graph (1 measurements)    A

FIG. 2

FIG. 3

FIG. 4

FIG. 5

FIG. 6

FIG. 7

FIG. 8

FIG. 9

FIG. 10

FIG. 11

FIG. 12

FIG. 13

FIG. 14

FIG. 15

FIG. 16

FIG. 17

FIG. 18

FIG. 19

EP 4 335 819 A1

Europäisches
Patentamt

European
Patent Office

Office européen
des brevets

# EUROPEAN SEARCH REPORT

**Application Number**

EP 22 38 2826

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| A | TRAN VAN TAM,A  SUNG GU KANG,A  KADUMUDI FIROZ BABU,A  EUN-SUOK OH,A  SEUNG GEOL LEEB, WON MOOK CHOI: "Synthesis of B-doped graphene quantum dots as a metal-free electrocatalyst for the oxygen reduction reaction", J.MATER. CHEM. A, vol. 5, 26 April 2017 (2017-04-26), pages 10537-10543, XP002808522, DOI: 10.1039/c7ta01485f * experimental section; page 10538 * | 1-13 | INV.<br>C01B32/15<br>C09K11/07<br>H01G11/00 |
| A | CN 103 881 708 A (UNIV ZHEJIANG NORMAL) 25 June 2014 (2014-06-25) * claims 1-7 * * machine translation * | 1-13 | |
| A | HAITAO LI ET AL: "Carbon nanodots: synthesis, properties and applications", JOURNAL OF MATERIALS CHEMISTRY, vol. 22, no. 46, 1 January 2012 (2012-01-01), page 24230, XP055368373, GB ISSN: 0959-9428, DOI: 10.1039/c2jm34690g * the whole document * | 1-13 | |

**TECHNICAL FIELDS SEARCHED (IPC)**

C01B
H05B
H01G
C09K
H01L

The present search report has been drawn up for all claims

| Place of search | Date of completion of the search | Examiner |
|---|---|---|
| The Hague | 26 January 2023 | Gerwann, Jochen |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P04C01)

## ANNEX TO THE EUROPEAN SEARCH REPORT
## ON EUROPEAN PATENT APPLICATION NO.

EP 22 38 2826

This annex lists the patent family members relating to the patent documents cited in  the above-mentioned European search report.
The members are as contained in the European Patent Office EDP file on
The European Patent Office is in no way liable for these particulars which are merely given for the purpose of information.

26-01-2023

| Patent document cited in search report | | Publication date | Patent family member(s) | Publication date |
|---|---|---|---|---|
| CN 103881708 | A | 25-06-2014 | NONE | |

For more details about this annex : see Official Journal of the European Patent Office, No. 12/82

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Non-patent literature cited in the description**

- **LI.** *J. Mater. Chem.,* 2012, vol. 22, 24230
- **MIAO.** *Nano Today,* 2020, vol. 33, 100879
- **JAHAN.** *Anal. Chem.,* 2013, vol. 85, 10232-10239
- **GUTIÉRREZ-SÁNCHEZ.** *Carbon,* 2020, vol. 159, 303-310
- **GUERRERO-ESTEBAN.** *Sensors and Actuators: B Chemical,* 2021, vol. 330, 129389
- **HORCAS ; R. FERNÁNDEZ.** *Review of Scientific Instruments,* 2007, vol. 78, 013705